# EUROPÄISCHE PATENTSCHRIFT

(11) **EP 2 524 394 B1**
(45) Veröffentlichungstag und Bekanntmachung des Hinweises auf die Patenterteilung: **31.07.2013**
(21) Anmeldenummer: 11799363.4
(22) Anmeldetag: 24.11.2011
(51) Int. Cl.: H01L 23/538

(54) **ELEKTRONISCHES BAUTEIL, VERFAHREN ZU DESSEN HERSTELLUNG UND LEITERPLATTE MIT ELEKTRONISCHEM BAUTEIL**
ELECTRONIC DEVICE, METHOD FOR PRODUCING THE LATTER, AND PRINTED CIRCUIT BOARD COMPRISING ELECTRONIC DEVICE
COMPOSANT ÉLECTRONIQUE, PROCÉDÉ POUR SA FABRICATION ET PLAQUETTE DE CIRCUITS IMPRIMÉS COMPORTANT UN COMPOSANT ÉLECTRONIQUE

(30) Priorität: 29.11.2010 DE 102010060855
(43) Veröffentlichungstag der Anmeldung: 21.11.2012
(73) Patentinhaber: Schweizer Electronic AG, 78713 Schramberg (DE)
(72) Erfinder: GOTTWALD, Thomas, 78655 Dunningen-Seedorf (DE); RÖSSLE, Christian, 78112 St. Georgen (DE)
(74) Vertreter: Hössle Patentanwälte Partnerschaft
(86) Internationale Anmeldenummer: PCT/EP2011/005912
(87) Internationale Veröffentlichungsnummer: WO 2012/072212

(56) Entgegenhaltungen:
- DE-A1- 10 031 952
- US-A1- 2008 251 903

## Beschreibung

Die vorliegende Erfindung betrifft ein elektronisches Bauteil sowie ein Verfahren zu dessen Herstellung.

Aus der DE 10 2009 013 818 A1 ist ein Verfahren zur Herstellung einer elektronischen Vorrichtung bekannt, bei dem nach dem Bereitstellen eines Trägers mit einer ersten leitenden Schicht über dieser ersten leitenden Schicht eine erste isolierende Schicht aufgebracht wird und mindestens eine Durchgangsverbindung von einer ersten Seite der ersten isolierenden Schicht zu einer zweiten Seite der ersten isolierenden Schicht erzeugt wird. Mindestens zwei Halbleiterchips werden an dem Träger angebracht und eine zweite isolierende Schicht wird über dem Träger aufgebracht. Dann wird die zweite isolierende Schicht geöffnet, bis der Träger freigelegt ist und eine Metallschicht wird über der geöffneten zweiten isolierenden Schicht abgeschieden, woraufhin die mindestens zwei Halbleiterchips getrennt werden.

Aus der US 2008/251903 A1 ist ein elektronisches Bauteil mit einer elektrisch leitenden Kernschicht mit einer beidseitig aufgebrachten ersten Schicht aus elektrisch leitendem Material und mit mindestens einem in einer Ausnehmung der ersten Schicht angeordneten elektronischen Bauelement bekannt, wobei die erste Schicht jeweils mit einer elektrisch isolierenden, thermisch leitfähigen Schicht bedeckt ist und auf der thermisch leitfähigen Schicht jeweils eine weitere Schicht aus elektrisch leitendem Material vorgesehen ist.

Demgegenüber wird erfindungsgemäß ein elektronisches Bauteil mit den Merkmalen des Anspruchs 1, ein Verfahren zu deren Herstellung mit den Merkmalen des Anspruchs sowie eine Leiterplatte mit erfindungsgemäßen Bauteilen mit den Merkmalen des Anspruchs 10 und ein Verfahren zum Integrieren eines elektronischen Bauteils in eine Leiterplatte mit den Merkmalen des Anspruchs 13 vorgeschlagen.

Das erfindungsgemäße elektronische Bauteil stellt eine kostengünstige Alternative zu Ausführungen aus Keramik dar. Gegenüber Ausführungsformen aus Keramik ist das elektronische Bauteil außerdem mit einer deutlich geringeren Bruchgefahr behaftet. Da die sonst üblichen langen Bonddrähte aus Aluminium durch kurze Vias aus Kupfer ersetzt sind, ist eine deutliche Verringerung des Einschaltwiderstands die Folge. Darüber hinaus ist mit der erfindungsgemäßen Ausgestaltung eine Reduzierung der Chipgröße möglich, da die verwendete galvanische Ankontaktierung weniger Fläche benötigt als die sonst üblichen Bonddrähte. Aufgrund des symmetrischen Schichtaufbaus verfügt das elektronische Bauteil über eine erhöhte Planarität. Die Differenz der thermischen Ausdehnungskoeffizienten zwischen den Chips und den Kontaktierungen ist verringert, woraus eine Steigerung der Zuverlässigkeit resultiert. Ein weiterer Vorteil besteht darin, dass die elektrische Isolierung, z.B. zu einem Motorengehäuse, bereits durch das Dielektrikum in dem Bauteil-Modul integriert ist. Das erzeugte Bauteil kann direkt in eine Leiterplatte integriert werden, was eine kostengünstige Komplettlösung darstellt.

Weitere Vorteile und Ausgestaltungen der Erfindung ergeben sich aus der Beschreibung und der beiliegenden Zeichnung.

Es versteht sich, dass die voranstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Die Erfindung ist zur Veranschaulichung anhand von Ausführungsbeispielen in der Zeichnung schematisch und nicht maßstabsgetreu dargestellt und wird im folgenden unter Bezugnahme auf die Zeichnung ausführlich beschrieben.
Figuren 1 bis 3 veranschaulichen das erfindungsgemäße Erzeugen eines ersten Halberzeugnisses bei der Herstellung eines elektronischen Bauteils.
Figur 4 zeigt eine Draufsicht auf ein Layout einer Ausführungsform des ersten Halberzeugnisses.
Figur 5 veranschaulicht das erfindungsgemäße Erzeugen eines zweiten Halberzeugnisses bei der Herstellung eines elektronischen Bauteils.
Figur 6 bis 8 veranschaulichen das Verlegen, Laminieren und weitere Verarbeiten der drei Halberzeugnisse zum Herstellen eines elektronischen Bauteils.
Figur 9 zeigt eine Ausführungsform eines fertigen erfindungsgemäßen elektronischen Bauteils.
Figur 10 zeigt eine Leiterplatte mit integriertem Bauteil gemäß der Erfindung im Querschnitt.
Figur 11 zeigt eine weitere Ausführungsform einer Leiterplatte mit integriertem Bauteil gemäß der Erfindung im Querschnitt.
Figur 12 zeigt ein Bauteil gemäß der Erfindung in seitlicher Schnittdarstellung mit integriertem Bauelement.
Figur 13 zeigt ein Bauteil gemäß der Erfindung in seitlicher Schnittdarstellung mit integriertem Interposer mit Bauelement.

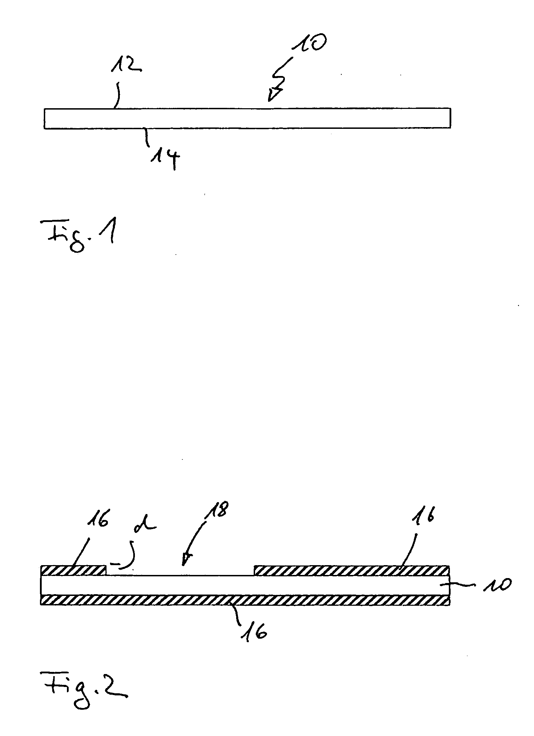

Gemäß dem erfindungsgemäßen Verfahren wird ein Substrat 10 aus elektrisch leitendem Material mit einer Oberseite 12 und einer Unterseite 14 bereitgestellt (Figur 1). Bei dem Substrat kann es sich bspw. um ein Blech aus Kupfer handeln, grundsätzlich sind aber auch andere leitfähige Materialien möglich, die dem Fachmann bekannt sind. Kupfer verbindet drei günstige Eigenschaften, nämlich gute elektrische Leitfähigkeit, gute thermische Leitfähigkeit und es ist - verglichen mit anderen Materialien, die vergleichbare Leitfähigkeitseigenschaften aufweisen - zu vernünftigen Preisen erhältlich. Die Dimensionen des Substrats 10 können vom Fachmann im Einzelfall und unter Berücksichtigung der spezifischen Anforderungen gewählt werden. Eine typische Abmessung könnte bspw. 600 mm x 600 mm auf 0,2 bis 1 mm Dicke sein.

Optional kann ein kostengünstigeres Metall gewählt werden, das andere Ätzeigenschaften aufweist als das abgeschiedene Metall, mit der Folge, dass dann ein selektives Ätzen nur des Trägers möglich ist. So kann bspw. Aluminium als Trägermaterial verwendet. werden, das zuvor verkupfert wurde. Damit sind Einsparungen bei den Kosten und beim Gewicht möglich.

In einem nächsten Schritt wird auf das Substrat 10 eine erste Schicht 16 aus elektrisch leitendem Material aufgebracht. Die erste Schicht 16 wird auf der Oberseite 12 und/oder der Unterseite 14 des Substrats 10 aufgebracht. Das Aufbringen erfolgt bspw. durch Abscheiden (Aufplattieren, galvanisches/elektrochemisches Abscheiden) oder durch andere geeignete technische Maßnahmen (wie bspw. Aufsputtern, Vakuumabscheidung usw.), die dem Fachmann bekannt sind.

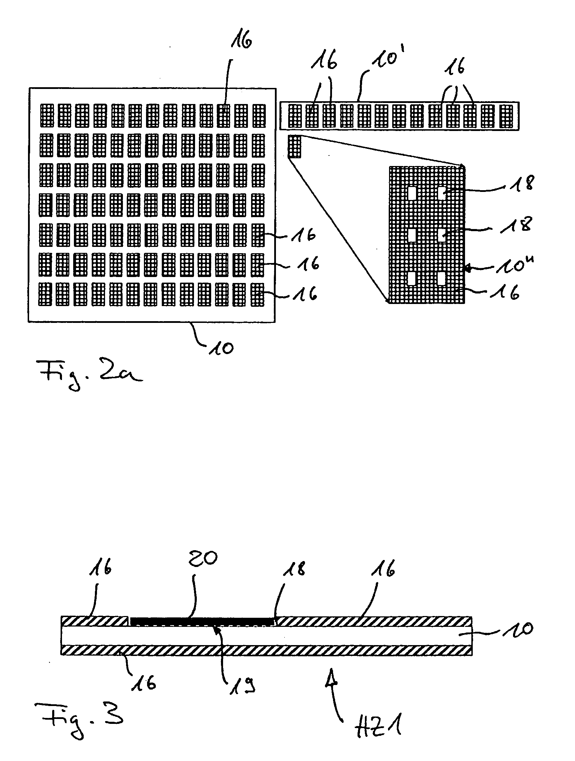

Das Aufbringen der ersten Schicht 16 auf dem Substrat 10 erfolgt erfindungsgemäß derart, dass mindestens eine Ausnehmung 18 erzeugt wird. Die Abmessungen (Grundrissfläche und Tiefe) der Ausnehmung 18 sind derart gewählt, dass die Ausnehmung 18 ein gewünschtes elektronisches Bauelement 20 (vgl. Figur 3) aufnehmen kann, das in einem nächsten Schritt in die Ausnehmung 18 auf dem Substrat 10 aufliegend eingesetzt wird. Bei dem elektronischen Bauelement 20 handelt es sich bspw. um einen Leistungs-Halbleiterchip oder ein anderes vergleichbares Bauelement. Die Tiefe d der Ausnehmung 18 wird z.B. so gewählt, dass die Höhe des einzusetzenden Bauelements 20 zuzüglich einer vorzusehenden Verbindungsschicht 19 zwischen Substrat 10 und einer Unterseite des Bauelements 20 etwas geringer ist, als die Tiefe d der Ausnehmung. Oder mit anderen Worten: die Plattierung (Schicht 22) ist etwas dicker als das einzusetzende Bauelement plus Verbindungsschicht. Bei der Verbindungsschicht 19 kann es sich bspw. um eine Lötschicht, eine organische Schicht oder einen geeigneten Kleber handeln. Wahlweise kann die Oberfläche des Substrats 10 im Bereich der Ausnehmung 18 mit einem geeigneten Edelmetall (wie Ag, Au, Sn o. dgl.) zur Ausbildung einer Kontaktierungsfläche für das Bauelement versehen sein. Durch geeignete Kombination von Beschichtungsmaterial für das elektronische Bauelement (bzw. den Chip) 20 und Beschichtung der Oberfläche des Substrats 10 können Verbindungen erzeugt werden, die nach dem Löten einen höheren Schmelzpunkt aufweisen als vor dem Löten. Dies wird bspw. durch die Kombination Gold (Au) auf dem Bauelement und Zinn (Sn) auf dem Substrat erreicht. Sn schmilzt bei 232 °C und es kommt zum Lötprozess. Dabei bilden sich intermetallische Phasen AuSn aus, deren Schmelzpunkt höher liegt als 232 °C. Dies verhindert ein späteres Wiederaufschmelzen bei einer Weiterverarbeitung.

Das elektronische Bauelement ist von seinen Oberflächen so beschaffen, dass die Unterseite an die vorgesehene Verbindungstechnik angepasst ausgeführt ist, bspw. mit einer lötfähigen Oberfläche, wenn gelötet werden soll. Die Oberseite des Bauelements ist dabei so ausgebildet, dass es für eine spätere galvanische Ankontaktierung geeignet ist, z.B. durch Verkupferung der Kontaktflächen.

Das beschriebene erfindungsgemäße Vorgehen des Ausbildens einer Ausnehmung zum Aufnehmen des Chips oder anderen Bauelements hat den Vorteil, dass das Bauelement in einem späteren Verfahrensschritt des Verpressens/Laminierens vor der Einwirkung mechanischen Drucks geschützt ist, indem die Höhe der Plattierung (und somit die Tiefe d der Ausnehmung) etwas größer gewählt wird, als die Dicke des Bauelements plus Verbindungsschicht. Dadurch wird gewährleistet, dass die Oberfläche des Bauelements zumindest so viel unterhalb der Oberfläche der Schicht 22 zu liegen kommt, dass beim Verpressen kein schädlicher Druck auf das Bauelement ausgeübt wird. Das Herstellen der Ausnehmung durch Aufbringen einer leitenden Schicht um die Ausnehmung herum hat den Vorteil, dass die Ausnehmung rechte Winkel und senkrechte Flächen aufweist (was durch Ätzen nicht und nur sehr aufwendig erzielt werden kann), so dass die Ausnehmung sehr passgenau auf die Größe des einzusetzenden Bauelements ausgebildet werden kann.

Zum Ausgleich von Bestückungstoleranzen ggf. vorgesehene Freisparungen um das Bauelement 20 können nach dessen Bestückung und Verlötung mit einem geeigneten Material vergossen werden, bspw. mit einer handelsüblichen Vergussmasse.

Nach dem bereits beschriebenen Einsetzen des Bauelements 20 in die dafür vorgesehene Ausnehmung 18 ist das erste Halberzeugnis HZ1 erzeugt.

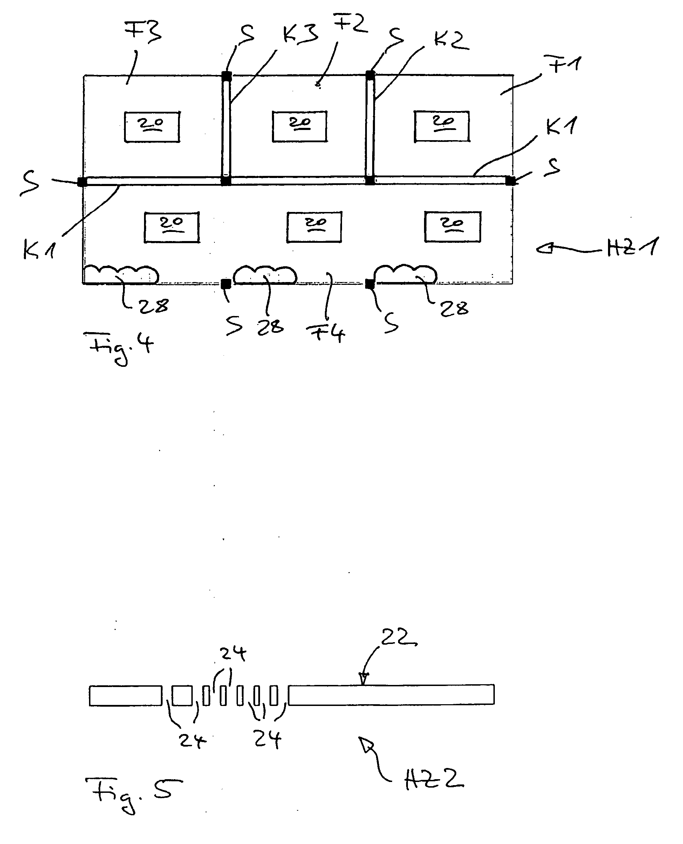

In Ausgestaltung (vgl. Figur 4) kann das erste Halberzeugnis mit durch Kanäle K1, K2, K3 definierten Feldern F1, F2, F3, F4 versehen werden. Dabei handelt es sich um Felder F1, F2, F3, F4, die nach Fertigstellung elektrisch voneinander isoliert sein sollen. Hierzu werden in die erste Schicht 16 und das Substrat 10 Kanäle K1, K2, K3 eingebracht, bspw. durch Ätzen, die zu diesem Zeitpunkt (noch) Stege S aufweisen, die sich quer durch die Kanäle K1, K2, K3 und diese mechanisch überbrückend erstrecken und eine Stabilitätsfunktion haben (Haltestege). Nach dem (nachfolgend noch zu beschreibenden) Laminiervorgang werden diese Haltestege mittels geeigneter Prozesse entfernt, bspw. durch Bohren, Fräsen, Stanzen u.dgl. Dadurch werden potential-getrennte Bereiche in dem elektronischen Bauteil erzeugt. Die in der Darstellung der Figur 4 im unteren Bereich des ersten Halberzeugnisses HZ1 erkennbaren halbkreis- bzw. teilkreisförmigen Freisparungen 28 dienen zur Potentialtrennung für Durchgangsbohrungen im fertigen Bauteil. Die wie voranstehend beschrieben erzeugten Felder F1, F2, F3, F4 dienen erfindungsgemäß zur Bereitstellung von Flächen zur Wärmespreizung für die elektronischen Bauelemente 20. Die Größe jedes Feldes F1, F2, F3, F4 wird derart gewählt, dass jedem der bestückten Bauelemente eine im wesentlichen gleich große Wärmespreizungsfläche zugeordnet ist.

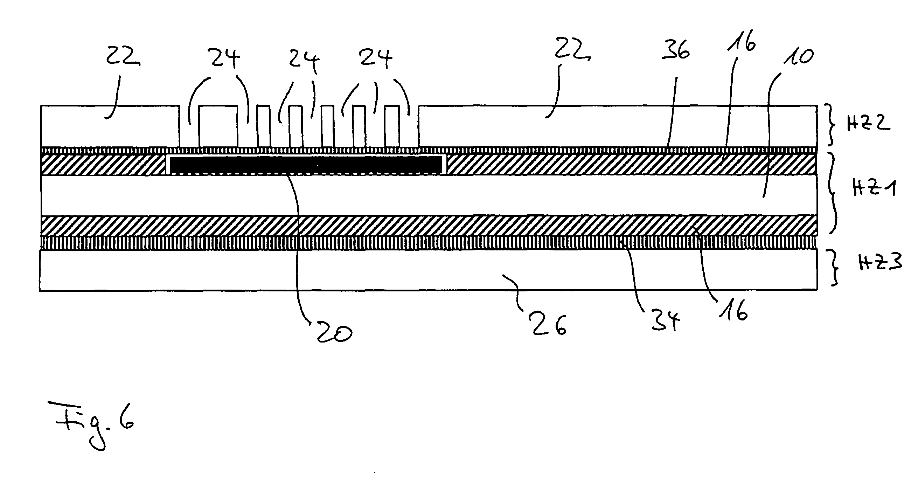

Die beschriebenen Kanäle können vor dem eigentlichen Laminierprozess verfüllt werden, um die vor dem Verpressen in den Schichtaufbau einzubringende Harzmenge (vgl. Figur 6) zu reduzieren. Dies kann bspw. erforderlich sein, wenn einerseits sehr dünne Isolationsabstände zwischen den drei Halberzeugnissen HZ1, HZ2 und HZ3 gewünscht sind, andererseits aber lange und breite Kanäle zu verfüllen sind. Dies kann bspw. mittels Druckprozess oder Roller-Coater erfolgen. Das Harz muss nicht unbedingt speziell thermisch leitfähig sein.

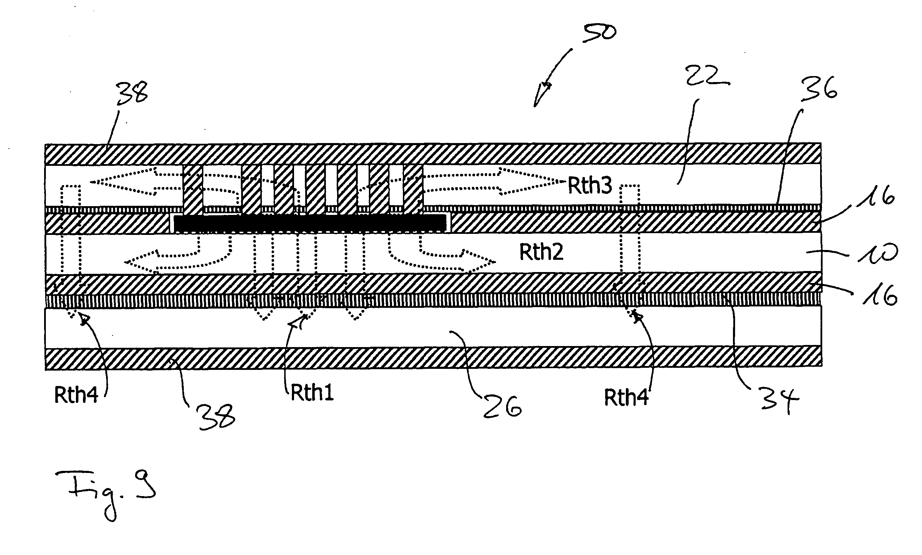

Die voranstehend beschriebenen Felder dienen im Rahmen eines Aspektes der vorliegenden Erfindung dazu, den auf den Feldern anzuordnenden Bauelementen jeweils gleiche Bauteil-Flächen zur "symmetrischen" Wärmespreizung zuzuordnen. "Symmetrisch" in diesem Zusammenhang bedeutet, dass die von den Bauelementen im Betrieb entwickelte Wärme aufgrund der zugeordneten gleich großen Flächen gleichmäßig abgeleitet wird, wie dies auch nachfolgend unter Bezug auf die Darstellung der Figur 9 noch erläutert wird.

In Ausgestaltung der Erfindung kann das Substrat 10 nach dem in Figur 2 veranschaulichten Verfahrensschritt vereinzelt werden, wie dies in Figur 2a veranschaulicht ist.

Figur 2a zeigt links eine Draufsicht auf ein Substrat 10 mit einer Vielzahl (im dargestellten Ausführungsbeispiel: 91) von Bauteilkarten, die zu bestücken sind. Wie in der Darstellung der Figur 2a rechts zu erkennen ist, kann eine Vereinzelung zu Zwecken der Bestückung (mit elektronischen Bauelementen 20 wie beschrieben) als Streifen 10' oder als Einzelkarten 10" erfolgen. Im Ausführungsbeispiel verfügt die vergrößert dargestellte Einzelkarte 10' über sechs Ausnehmungen 18. Nach dem Bestücken der Ausnehmungen mit den einzusetzenden Bauelementen werden die Streifen bzw. Einzelkarten zur Weiterverarbeitung wieder zusammengesetzt, was bspw. durch Einsetzen der Streifen bzw. Einzelkarten in ein geeignetes Tray (nicht dargestellt) erfolgt.

Zur Erzeugung eines zweiten erfindungsgemäßen Halberzeugnisses HZ2 wird nun ein erstes Plattenelement 22 aus elektrisch leitendem Material bereitgestellt (vgl. Figur 5). Bei dem ersten Plattenelement handelt es sich um ein plattenförmiges Element, bspw. um ein Blech aus geeignetem elektrisch leitendem Material. Bei diesem Material kann es sich - aus den bereits voranstehend dargelegten Erwägungen - um Kupfer handeln. Die Abmessungen des ersten Plattenelements orientieren sich im Hinblick auf die nachstehend noch beschriebene Weiterverarbeitung an den Maßen des Substrats 10, also im beschriebenen Ausführungsbeispiel ca. 600 mm x 600 mm. Die Dicke kann wiederum ca. 0,2 mm betragen; sie kann vom Fachmann jedoch auch dicker oder dünner gewählt werden, je nach den Erfordernissen des Einzelfalls.

Das Plattenelement wird nach dem Bereitstellen an einer oder mehreren Stellen mit durchgehenden Löchern 24 für spätere Durchkontaktierungen versehen. Die Durchkontaktierungslöcher 24 können durch Bohren, Stanzen, Ätzen, Laserbearbeitung oder andere dem Fachmann geläufige Verfahren erstellt werden.

Danach ist das zweite Halberzeugnis HZ2 gemäß der Erfindung fertig.

Anschließend wird ein zweites Plattenelement 26 aus elektrisch leitendem Material als drittes Halberzeugnis HZ3 bereitgestellt (nicht separat dargestellt).

In dem ersten Halberzeugnis HZ1 und dem dritten Halberzeugnis HZ3 können dem Fachmann an und für sich bekannte Ausrichtungselemente vorgesehen sein, die der Ausrichtung der beiden Halberzeugnisse zueinander beim Bilden des Schichtaufbaus dienen.

Die Oberflächen aller oder einzelner der drei Halberzeugnisse HZ1, HZ2, HZ3 können vor dem nun folgenden Verlegen der Schichten zum Erzielen einer verbesserten Haftung der später verwendeten Laminierharzen durch geeignete Maßnahmen aufgerauht und/oder mit haftungsverbessernden Schichten (Haftvermittler) überzogen werden. Im Falle des ersten Halberzeugnisses kann ein geeigneter Haftvermittler gleichzeitig sowohl auf der Oberfläche des Halberzeignisses als auch auf der Oberfläche des elektronischen Bauelements aufgetragen werden.

In Figur 6 ist die Ausrichtung der bislang erzeugten drei Halberzeugnisse HZ1, HZ2, HZ3 veranschaulicht.

Auf das dritte Halberzeugnis HZ3 wird das erste Halberzeugnis HZ1 aufgesetzt, wobei die Seite des ersten Halberzeugnisses HZ1 mit aufgesetztem Bauelement 20 nach oben und somit weg von dem dritten Halberzeugnis HZ3 weist. Zwischen die beiden Halberzeugnisse wird vor dem Aufsetzen als Zwischenlage eine erste Prepreg-Schicht 34 eingebracht. Diese erste Prepreg-Schicht 34 kann derart ausgestaltet sein, dass sie sich nicht in die gegenseitigen Eingriffstellen eventuell vorhandener Ausrichtungselemente erstreckt.

Auf die erste Schicht 16 auf der Oberseite 12 des ersten Halberzeugnisses HZ1 wird, nach Auflegen einer zweiten Prepreg-Schicht 36, das zweite Halberzeugnis HZ2 aufgesetzt, derart dass die durchgehenden Löcher 24 des zweiten Halberzeugnisses HZ2 in gewünschter Ausrichtung über dem elektronischen Bauelement 20 zu liegen kommen, um später als Durchkontaktierungen zu dem Bauelement 20 dienen zu können.

Optional kann das Prepreg im Bereich der späteren Durchkontaktierungen (durchgehende Löcher 24) vorgebohrt sein. Dadurch ist das Glasgewebe im Bereich der Vorbohrungen entfernt, wodurch das nachfolgende Laserbohren erleichtert wird, wenn das Prepreg auf die Durchkontaktierungslöcher 24 ausgerichtet aufgelegt wird, da der Laser nach dem Laminieren lediglich die Harzfüllung abtragen muss.

Bei der Auswahl der Prepreg-Schichten sollte auf eine gute thermische Leitfähigkeit des Materials geachtet werden. Bspw. kann hochthermisch leitfähiges Material verwendet werden. Es können Prepregs mit Harzen, die Füllstoffe mit hoher Leitfähigkeit enthalten, wie bspw. A1203 oder TiN, verwendet werden. Die Dicke der Prepreg-Schicht wird abhängig von der erforderlichen thermischen Leitfähigkeit und anderen Parametern, wie bspw. die Durchschlagfestigkeit, gewählt.

Die so entstandene Sandwichstruktur (Schichtaufbaustruktur) der Figur 6 wird dann unter dem Fachmann bekannten Prozessparametern verpresst bzw. laminiert.

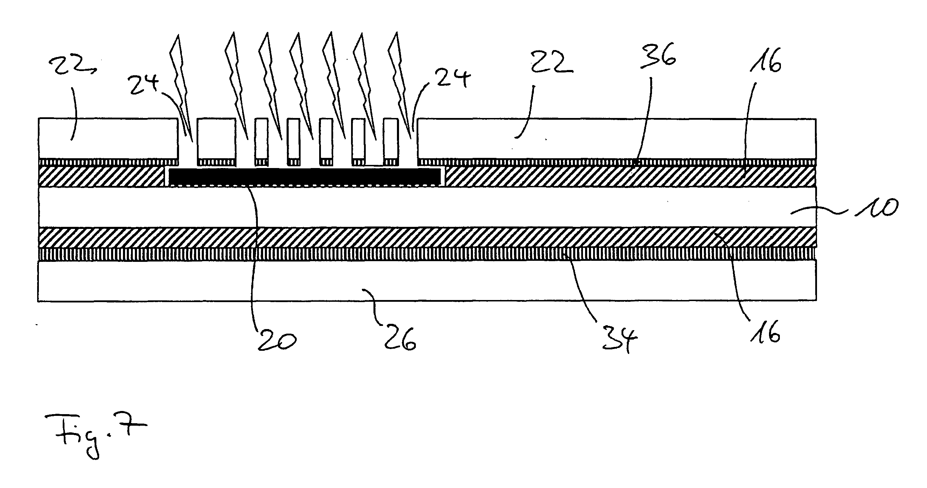

In einem folgenden Verfahrensschritt werden die durch das Laminieren mit Prepreg-Harz gefüllten Durchkontaktierungslöcher 24 freigelegt (einschließlich eventuell vorhandener Glasfasern). Dies kann durch dem Fachmann bekannte geeignete Maßnahmen, wie bspw. durch Lasern, wie dies in Figur 7 durch die stilisierten Laserblitze angedeutet ist, erfolgen.

Nach dem Entfernen des Dielektrikums aus den durchgehenden Löchern 24 wird auf der Dielektrikumswandung in den Löchern 24 aufgrund der Prepreg-Schicht 36 direkt oberhalb der Oberfläche des elektronischen Bauelements 20 in an sich bekannter Art und Weise eine dünne elektrisch leitende Schicht erzeugt. Diese Schicht kann bspw. durch chemisches Abscheiden von bspw. Kupfer erzeugt werden.

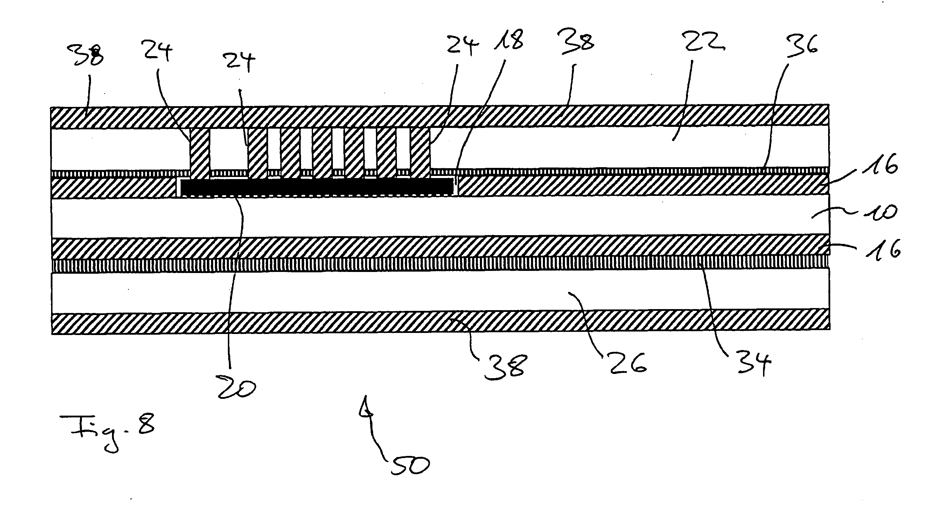

Auf der obersten Schicht 22 der entstandenen Laminat-Zwischenstruktur wird dann eine Deckschicht 38 aus elektrisch leitendem Material aufgebracht. Bei dem elektrisch leitenden Material kann es sich bspw. wiederum um Kupfer handeln, das durch Galvanisieren derart aufgebracht wird, dass die Durchkontaktierungslöcher 24 vollständig gefüllt oder zumindest angefüllt werden, um eine gute Ankontaktierung des darunter liegenden elektronischen Bauelements 20 zu gewährleisten. Die Deckschicht kann auch - wie in dem Ausführungsbeispiel der Figur 8 dargestellt - auf der Unterseite (unterste Schicht 26) der entstandenen Laminat-Zwischenstruktur aufgebracht werden.

Figur 9 zeigt eine Querschnittdarstellung eines erfindungsgemäßen elektronischen Bauteils 50, das aus einem Kupfer- bzw. Metallkern aus dem vormaligen Substrat 10 und den darauf aufgebrachten galvanischen Kupfer- bzw. Metallschichten 16, darauf (oben und unten) angeordneten thermisch leitfähigen Dielektrikumschichten 34, 36 und wiederum auf diesen (oben und unten) ausgebildeten weiteren Kupfer- bzw. Metallschichten 22, 26, 38 mit einem eingebetteten und über Metall-/Kupfer-Vias 24 ankontaktierten Bauelement bzw. Chip 20 besteht.

Dieser erfindungsgemäße Aufbau eines elektronischen Bauteils gewährleistet eine stabile und thermisch hoch leistungsfähige Anordnung, die im Vergleich zu ähnlich leistungsfähigen Keramiksubstraten deutlich kostengünstiger herstellbar und kleiner dimensionierbar ist und eine höhere Bruchfestigkeit aufweist. Durch die galvanische Ankontaktierung ist eine kleinere Chipdimensionierung ermöglicht, da keine Rücksicht auf Dickdrähte zum Anbonden genommen werden muss.

In Figur 9 sind die sogenannten Entwärmungspfade des Bauteils 50 anhand punktierter Pfeile, verbunden mit unterschiedlichen thermischen Widerständen Rth1 bis Rth4, angedeutet. Wie aus dieser Darstellung ersichtlich ist, verfügt das erfindungsgemäß aufgebaute Bauteil 50 über eine hohe Zahl derartiger Entwärmungspfade, die dafür sorgen, dass in dem elektronischen Bauelement erzeugte Wärme gezielt abgeleitet wird. Dies wird u.a. durch die Verwendung von zwei Kupferebenen zur elektrischen und thermischen Verbindung erzielt. Dadurch wird die Verwendung von Bauelementen höherer Leistung bei gleicher Fläche (höhere Leistungsdichte) und/oder ein Flächengewinn bei der Gestaltung (Design) der Leiterbahnstrukturen ermöglicht, ohne die Gefahr einer Überhitzung. Der Effekt wird zur Wärmespreizung verwendet, d.h. der thermische Widerstand sinkt bei Erhöhung der Querschnittfläche proportional.

Im Zusammenhang mit der vorliegenden Erfindung verwendete Materialien zeichnen sich vorteilhafterweise durch besonders gute Wärmeleitkoeffizienten aus. Übliche Prepreg-Harz-Materialien weisen eine thermische Leitfähigkeit von ca. 0,2 bis 0,3 W/mK auf. Möglich sind jedoch auch Materialien mit einer Wärmeleitfähigkeit von 0,8 bis 2,0 W/mK.

Vorteilhafterweise sind die Flächen der Felder F1, F2, F3 sowie ein Drittel der Fläche des Feldes F4 gleich groß (vgl. auch Figur 4), damit jedem Bauelement die gleiche Fläche zur Wärmespreizung zur Verfügung steht. Dabei ist berücksichtigt, dass Felder, auf denen mehrere Bauelemente/Chips zur Anordnung kommen, gegenüber Flächen mit nur einem Bauelement eine entsprechend um die Anzahl der Bauelemente vielfache Fläche aufweisen müssen, damit die erfindungsgemäße Wärme-Gleichableitung gewährleistet ist. Dadurch wird vermieden, dass sich ein Chip aufgrund unterschiedlicher Geometrien stärker aufheizt als die anderen Chips (sogenannter Hot-Spot-Effekt) und die Leistung des Gesamtsystems dann zum Abkühlen des einzelnen heißeren Chips gedrosselt werden muss.

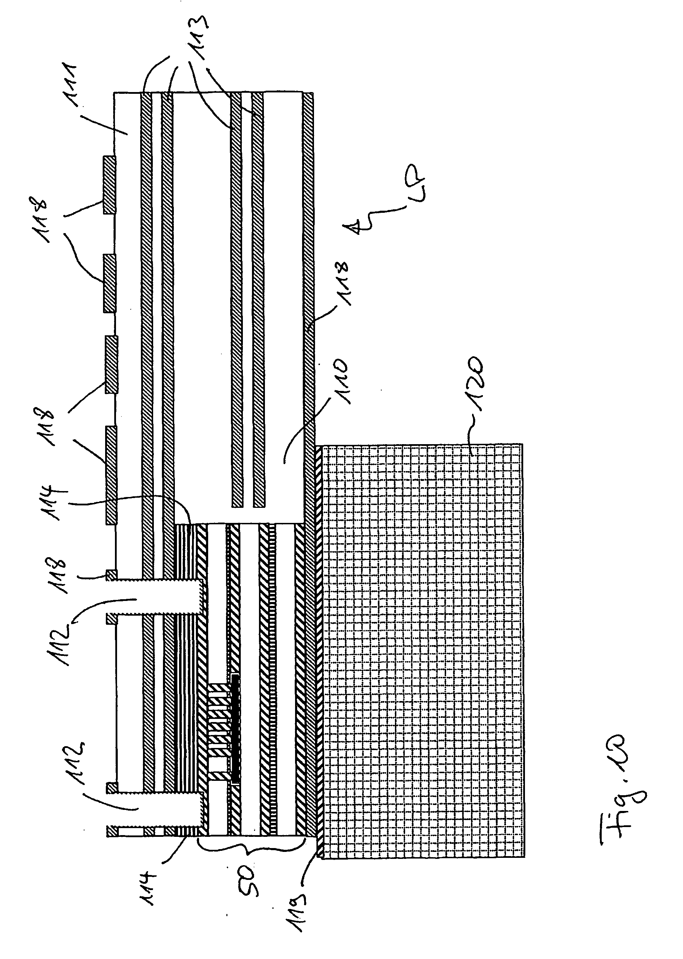

Das erfindungsgemäß hergestellte elektronische Bauteil 50 kann in eine Leiterplatte integriert werden, wie dies anhand Figur 10 veranschaulicht ist.

Dazu wird das elektronische Bauteil 50 in eine dafür vorgesehene Aussparung der Leiterplatte eingesetzt und mit dieser gemeinsam derart verpresst, dass nach dem Verpressen die Oberfläche der Leiterplatte bündig mit der Oberfläche des Bauteils abschließt. In der Darstellung der Figur 10 stellen weiße Schichten der Leiterplatte LP Dielektrikumschichten 110, 111 und schraffierte Schichten leitende Schichten 113 dar. Zwei eingezeichnete Sacklöcher 112 dienen zur Ankontaktierung zwischen Bauteil 50 und Leiterplatte LP. Direkt oberhalb des Bauteils 50 befindet sich eine (horizontal schraffierte) Schicht 114 mit geringer thermischer Leitfähigkeit. Zwischen dem Kühlkörper 120 und einer unteren (Kupfer-)Außenlage 118 der Leiterplatte LP kann eine TIM-Schicht 119 zur Ausbildung eines thermisch lückenlosen Spalts vorgesehen sein (TIM: thermal interface material).

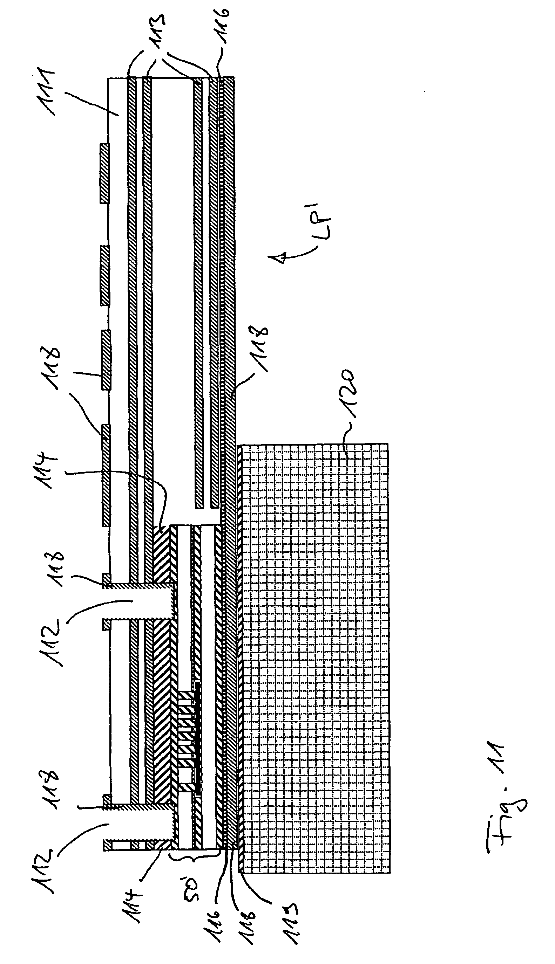

Beim Einbau in eine Leiterplatte LP kann auch alternativ auf die Schichtenfolge 34, 26, 38 des dritten Halberzeugnisses HZ3 verzichtet werden. Eine derartige Variante ist beispielhaft in Figur 11 dargestellt. Hier ist ein elektronisches Bauteil 50' ohne das dritte Halberzeugnis HZ3 direkt in eine Leiterplatte LP' integriert. Die Leiterplatte LP' weist einen grundsätzlich gleichen Aufbau wie in der Figur 10 auf, wobei zusätzlich an der Unterseite der Leiterplatte ein thermisch leitfähiges Prepreg 116, das sich über die Fläche der Leiterplatte und des integrierten Bauteils 50' erstreckt. Als gemeinsame Außenlage der Leiterplatte und des Bauteils 50' wird anschließend noch eine Kupferschicht 118 aufgebracht (die beim galvanischen Aufbringen einer Deckschicht zur Ausbildung der Durchkontaktierung der Sacklöcher 112 auf der Oberseite der Leiterplatte mit entsteht). Bei der Integration des Bauteils 50' mit der Leiterplatte LP' erfolgt ein gemeinsames Verpressen mit diesem thermisch leitfähigen Außenlagendielektrikum. Unterhalb des Bauteils 50' schließt sich an der Unterseite der Außenlage 116 wiederum die Kupferlage 118, eine TIM-Schicht 119 und ein Kühlkörper 120 an.

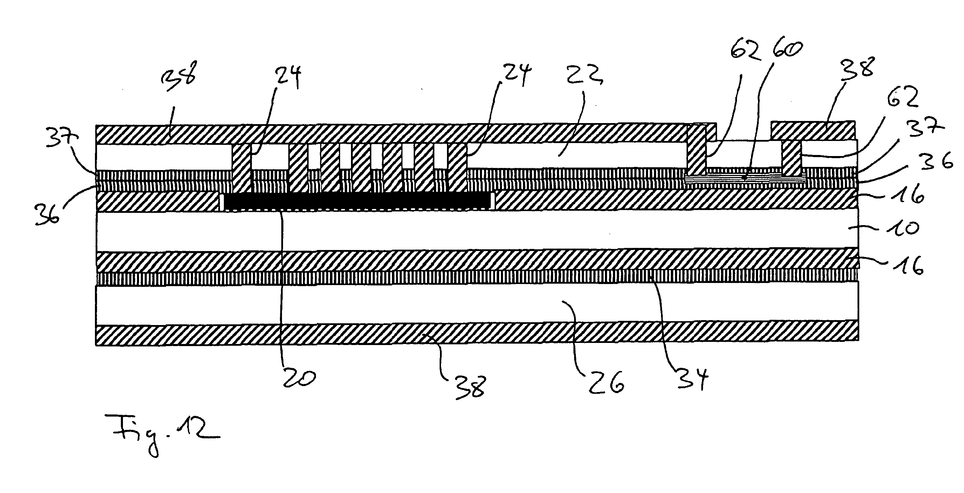

Alternativ kann die Leiterplatte auch so ausgestaltet sein, dass sie sich unterhalb des Bauteils erstreckt und die Kühlflächenfunktion erfüllt (nicht dargestellt), die in den beiden in den Figuren 11 und 12 dargestellten Ausführungsformen von dem Kühlkörper 120 übernommen wird.

Der Bereich der Leiterplatte oberhalb des Bauteils kann - wie bereits angedeutet - so ausgestaltet sein, dass ein schlechter Wärmefluss nach oben resultiert. Dadurch wird die Aufheizung eventuell temperaturempfindlicher Bauelemente auf der Leiterplatte vermieden bzw. zumindest reduziert. Zu diesem Zwecke kann bspw. alternativ oder zusätzlich zu der bereits in den Figuren 11 und 12 dargestellten Schicht 114 mit geringer thermischer Leitfähigkeit innerhalb dieser Schicht 114 mindestens ein Hohlraum (nicht dargestellt) oberhalb des Bauteils und direkt an dieses anschließend vorgesehen sein. Die elektrische als auch die mechanische Anbindung des Bauteils an die Leiterplatte erfolgt dann über die seitlichen Ränder und verbliebene Bereiche der Oberfläche.

In Ausgestaltung der Erfindung können zwischen dem ersten Halberzeugnis HZ1 und dem zweiten Halberzeugnis HZ2 zwei Prepreg-Schichten 36, 37 eingebracht werden, zwischen denen sich wiederum ein Bauelement befindet. Bei diesem Bauelement kann es sich bspw. um ein Bauelement 60 zur Strommessung bzw. Stromsensierung (sogenannter Shunt) handeln (in der dargestellten Ausführungsform ein Folien-Bauelement; vgl. Figur 12). Dessen Ankontaktierung erfolgt - wie bereits in anderem Zusammenhang voranstehend beschrieben - bspw. über ausplattierte Laserlöcher 62.

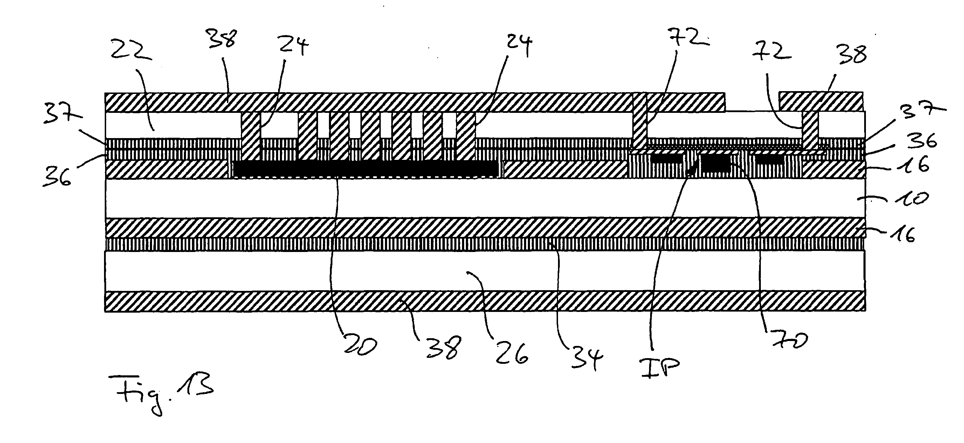

In weiterer Ausgestaltung kann - ähnlich wie im Zusammenhang mit Figur 12 beschrieben - zwischen die beiden Prepregschichten 36, 37 zwischen dem ersten Halberzeugnis HZ1 und dem zweiten Halberzeugnis HZ2 mindestens ein passives, diskretes Bauelement 70, bspw. mittels eines sogenannten Interposers IP, eingebracht werden, wie dies in Figur 13 veranschaulicht ist. Abhängig von dessen Bauhöhe kann ggf. ein Hohlraum bzw. eine Kavität 17 in dem ersten Halberzeugnis HZ1 zur Aufnahme des Interposers IP vorgesehen sein. Die Ankontaktierung erfolgt wiederum über ausplattierte Laserlöcher 72 o.dgl.

## Patentansprüche

1. Elektronisches Bauteil (50; 50') mit einer elektrisch leitenden Kernschicht (10) mit einer beidseitig aufgebrachten ersten Schicht (16) aus elektrisch leitendem Material und mit mindestens einem in einer Ausnehmung (18) der ersten Schicht (16) angeordneten elektronischen Bauelement (20), wobei die erste Schicht (16) oberhalb des elektronischen Bauelements (20) mit einer elektrisch isolierenden, thermisch leitfähigen Schicht (36) bedeckt ist und auf der thermisch leitfähigen Schicht (36) eine weitere Schicht (22) aus elektrisch leitendem Material vorgesehen ist, die wiederum mit einer Deckschicht (38) aus elektrisch leitendem Material überzogen ist, und mit des weiteren Durchkontaktierungen (24) aus dem Material der Deckschicht (38), die sich durch die das elektronische Bauelement (20) bedeckende elektrisch isolierende, thermisch leitfähige Schicht (36) und die weitere Schicht (22) aus elektrisch und thermisch leitendem Material zum Ankontaktieren des elektronischen Bauelements (20) erstrecken.

2. Elektronisches Bauteil (50) nach Anspruch 1, bei dem die erste Schicht (16) jeweils mit einer elektrisch isolierenden, thermisch leitfähigen Schicht (34, 36) bedeckt ist und auf der thermisch leitfähigen Schicht (34, 36) jeweils eine weitere Schicht (22, 26) aus elektrisch leitendem Material vorgesehen ist, die jeweils mit einer Deckschicht (38) aus elektrisch leitendem Material überzogen sind.

3. Elektronisches Bauteil (50; 50') nach Anspruch 1 oder 2, bei dem bei mehr als einem elektronischen Bauelement (20) jedem Bauelement (20) derart eine Fläche zur wärmespreizung zugeordnet ist, dass die Wärmespreizungsfläche für jedes montierte Bauelement (20) im wesentlichen gleich ist.

4. Verfahren zum Herstellen eines elektronischen Bauteils (50; 50') mit den folgenden Schritten:
- Erzeugen eines ersten Halberzeugnisses (HZ1) durch
- Bereitstellen eines Substrats (10) aus elektrisch leitendem Material mit einer Oberseite (12) und einer Unterseite (14),
- Aufbringen/Abscheiden einer ersten Schicht (16) aus leitendem Material auf die Oberseite (12) und/oder die Unterseite (14) des Substrats (10), wobei in der ersten Schicht (16) mindestens eine Ausnehmung (18) zur Aufnahme eines elektronischen Bauelements vorgesehen wird,
- Einsetzen eines Bauelements (20) in die mindestens eine Ausnehmung (18),
- Erzeugen eines zweiten Halberzeugnisses (HZ2) durch
- Bereitstellen eines ersten Plattenelements (22) aus elektrisch leitendem Material,
- Erzeugen von durchgehenden Löchern (24) für spätere Durchkontaktierungen in dem ersten Plattenelement (22),
- Verlegen der zwei Halberzeugnisse (HZ1, HZ2) in einer Schichtstruktur durch Auflegen des zweiten Halberzeugnisses (HZ2) auf das erste Halberzeugnis (HZ1) mit einer dazwischen vorgesehenen Prepreg-Schicht (36),
- Laminieren der Struktur,
- Freilegen der nach dem Laminieren mit Harz gefüllten Löcher (24) des ersten Plattenelements (22),
- zumindest teilweises Füllen der Löcher (24) mit leitfähigem Material (38) zur Durchkontaktierung.

5. Verfahren zum Herstellen eines elektronischen Bauteils (50) nach Anspruch 4, bei dem vor dem Schritt des Verlegens folgender Schritt erfolgt:
- Erzeugen eines dritten Halberzeugnisses (HZ3) durch
- Bereitstellen eines zweiten Plattenelements (26) aus elektrisch leitendem Material,
und der Schritt des Verlegens folgendes umfasst:
- Verlegen der drei Halberzeugnisse (HZ1, HZ2, HZ3) in einer Schichtstruktur durch Auflegen des ersten Halberzeugnisses (HZ1) auf das dritte Halberzeugnis (HZ3) und Auflegen des zweiten Halberzeugnisses (HZ2) auf das erste Halberzeugnis (HZ1) mit jeweils dazwischen vorgesehener Prepreg-Schicht (34, 36).

6. Verfahren nach Anspruch 4 oder 5, bei dem nach dem Bestücken mit dem mindestens einen elektronischen Bauelement (20) Freisparungen in der Ausnehmung (18) um das Bauelement (20) vor dem Verpressen aufgefüllt werden.

7. Verfahren nach einem der Ansprüche 4 bis 6, bei dem in die erste Schicht (16) und das Substrat (10) Kanäle (K1, K2, K3) eingebracht werden, wobei die Kanäle Haltestege (S) aufweisen, die nach dem Schritt des Laminierens entfernt werden.

8. Verfahren nach einem der Ansprüche 4 bis 7, bei dem in dem Schritt des Verlegens zwischen dem ersten Halberzeugnis (HZ1) und dem zweiten Halberzeugnis (HZ2) zwei Prepreg-Schichten (36, 37) eingebracht werden, wobei zwischen den beiden Prepreg-Schichten (36, 37) ein weiteres Bauelement (60) und/oder ein Interposer (IP) angeordnet wird, das bzw. der nach dem Schritt des Verpressens mittels ausplattierten Löchern (62, 72) ankontaktiert wird.

9. Verfahren nach Anspruch 8, bei dem bei dem Schritt des Erzeugens des zweiten Halberzeugnisses (HZ2) durchgehende Löcher zum Ankontaktieren des weiteren Bauelements (60) und/oder des Interposers (IP) vorgesehen werden.

10. Leiterplatte (LP; LP') mit einem elektronischen Bauteil (50; 50') nach einem der Ansprüche 1 bis 3.

11. Leiterplatte (LP; LP') nach Anspruch 10, bei der eine Oberfläche der Leiterplatte (LP; LP') bündig mit dem elektronischen Bauteil (50; 50') abschließt und sich ein Kühlkörper (120) an den bündigen Abschluss von Leiterplatte (LP; LP') und elektronischem Bauteil (50; 50') anschließt.

12. Leiterplatte (LP; LP') nach Anspruch 10 oder 11, bei der zwischen dem elektronischen Bauteil (50; 50') und darüber liegenden Leiterbahnen (113) der Leiterplatte (LP; LP') eine Schicht (114) mit geringer thermischer Leitfähigkeit vorgesehen ist.

13. Verfahren zum Integrieren eines elektronischen Bauteils (50, 50') in eine Leiterplatte, mit den Schritten des
- Bereitstellens eines elektronischen Bauteils (50, 50') nach einem der Ansprüche 1 bis 3,
- Bereitstellens einer Leiterplatte mit einer zur Aufnahme des elektronischen Bauteils (50; 50') vorgesehenen Aussparung,
- Einbringens einer Schicht (114) geringer thermischer Leitfähigkeit in die Aussparung,
- Einsetzens des elektronischen Bauteils (50; 50') in die Aussparung der Leiterplatte auf die Schicht (114) geringer thermischer Leitfähigkeit,
- Verpressens der derart entstandenen Schichtstruktur,
- Aufbringens einer eine gemeinsame Außenlage bildenden elektrisch leitenden Schicht (118), die auch zur Ankontaktierung zwischen dem elektronischen Bauteil (50; 50') und der Leiterplatte (LP; LP') dient.

14. Verfahren nach Anspruch 13, bei dem auf die die gemeinsame Außenlage bildende Schicht (118) im Bereich des elektronischen Bauteils (50; 50') ein Kühlkörper (120) aufgebracht wird.

15. Verfahren nach Anspruch 14, bei dem zwischen der elektrisch leitenden Schicht (118) und dem Kühlkörper (120) eine TIM-Schicht (119) zur Ausbildung eines thermisch lückenlosen Spalts eingebracht ist.

16. Verfahren nach einem der Ansprüche 13 bis 15, bei dem zwischen der Leiterplatte mit eingesetztem elektronischen Bauteil einerseits und der gemeinsamen Außenlage (118) andererseits ein thermisch leitfähiges Dielektrikum (116) eingebracht wird.

## Claims

1. An electronic device (50, 50') comprising an electrically conductive core layer (10) with a first layer (16) composed of electrically conductive material, said first layer (16) being applied on both sides, and with at least one electronic component (20) arranged in a recess (18) of the first layer (16), wherein the first layer (16) is covered above the electronic component (20) with an electrically insulating, thermally conductive layer (36), and a further layer (22) composed of electrically conductive material is provided on the thermally conductive layer (36), said further layer (22) being coated with a covering layer (38) composed of electrically conductive material, and furthermore comprising through-connections (24) composed of the material of the covering layer (38), the through-connections (24) extending through the electrically insulating, thermally conductive layer (36) covering the electronic component (20) and the further layer (22) composed of electrically and thermally conductive material for the purpose of making contact with the electronic component (20).

2. An electronic device (50) according to claim 1, wherein the first layer (16) is covered on each side with an electrically insulating, thermally conductive layer (34, 36), respectively, with a further layer (22, 26) composed of electrically conductive material provided on each thermally conductive layer (34, 36), respectively, said further layer (22, 26) being coated with a covering layer (38) composed of electrically conductive material, respectively.

3. The electronic device (50; 50') in accordance with claim 1 or 2, in which, in the event of more than one electronic component (20), each component (20) is assigned a surface for heat spreading in such a manner that the heat spreading surface for each installed component (20) is practically identical.

4. A method of making an electronic device (50; 50'), comprising the following steps:
- creating a first semi-finished product (HZ1) by
- providing a substrate (10) of electrically conductive material having an upper side (12) and a bottom side (14);
- applying/depositing a first layer (16) of conductive material on the upper side (12) and/or the bottom side (14) of the substrate (10), with at least one recess (18) for receiving an electronic component being provided in the first layer (16);
- inserting a component (20) in the at least one recess (18);
- creating a second semi-finished product (HZ2) by
- providing a first plate element (22) of electrically conductive material;
- creating through holes (24) in the first plate element (22) to subsequently form plated-through holes;
- arranging the two semi-finished products (HZ1, HZ2) as a layered structure by placing the second semi-finished product (HZ2) on the first semi-finished product (HZ1), with a prepreg layers (36) being provided in between;
- laminating the structure;
- uncovering the resin-filled holes (24) of the first plate element (22) after the step of laminating;
- at least partially filling the holes (24) with conductive material (38) for the purpose of creating a through-connection.

5. A method of making an electronic device (50) according to claim 4, comprising the following step before the step of arranging:
- creating a third semi-finished product (HZ3) by
- providing a second plate element (26) of electrically conductive material;
and wherein the step of arranging comprises
- arranging the three semi-finished products (HZ1, HZ2, HZ3) as a layered structure by placing the first semi-finished product (HZ1) on the third semi-finished product (HZ3), and by placing the second semi-finished product (HZ2) on the first semi-finished product (HZ1), with a prepreg layer (36) being provided in between, respectively.

6. The method according to claim 4 or 5, wherein, after the step of inserting the at least one electronic component (20), gaps in the recess (18) around the component (20) are filled before the pressing stage.

7. The method according to any one of claims 4 to 6, wherein channels (K1, K2, K3) are generated in the first layer (16) and the substrate (10), the channels having retaining studs (S) to be removed after the step of laminating.

8. The method according to any one of claims 4 to 7, wherein, during the step of arranging, two prepreg layers (36, 37) are placed between the first semi-finished product (HZ1) and the second semi-finished product (HZ2), with an additional component (60) and/or an interposer (IP) being positioned between the two prepreg layers (36, 37), the component or interposer being contacted via through-plated holes (62, 72) after the step of pressing.

9. The method according to claim 8, wherein, during the step of creating the second semi-finished product (HZ2), through holes for contacting the additional component (60) and/or the interposer (IP) are provided.

10. A printed circuit board (LP; LP') comprising an electronic device (50; 50') according to any one of claims 1 to 3.

11. The printed circuit board (LP; LP') according to claim 10, in which a surface of the printed circuit board (LP; LP') terminates flush with the electronic device (50; 50') and in which a heat sink (120) is connected to the flush junction of the printed circuit board (LP; LP') and the electronic device (50; 50').

12. The printed circuit board (LP; LP') according to claim 10 or 11, in which a layer (114) with low thermal conductivity is provided between the electronic device (50; 50') and conductive paths (113) of the printed circuit board (LP; LP') located above.

13. A method for integrating an electronic device (50, 50') into a printed circuit board, comprising the steps of
- providing an electronic device (50, 50') according to any one of claims 1 to 3;
- providing a printed circuit board comprising a recess for receiving the electronic device (50, 50');
- inserting a layer (114) with low thermal conductivity into the recess;
- inserting the electronic device (50, 50') into the recess of the printed circuit board onto the layer (114) with low thermal conductivity;
- pressing together the layered structure created thereby;
- applying an electrically conductive layer (118) forming a common outer layer which also serves for contacting the electronic device (50, 50') with the printed circuit board (LP, LP').

14. The method according to claim 13, wherein a heat sink (120) is mounted on the layer forming a common outer layer (118) in the area of the electronic device (50, 50').

15. The method according to claim 14, wherein a TIM layer (119) is placed between the electrically conductive layer (118) and the heat sink (120) to form a thermally uninterrupted junction.

16. The method according to any one of claims 13 to 15, wherein a thermally conductive dielectric (116) is placed between the printed circuit board with an inserted electronic device on the one hand and the common outer layer (118) on the other hand.

## Revendications

1. Composant électronique (50, 50') comprenant une couche centrale électriquement conductrice (10) avec une première couche (16) appliquée sur les deux côtés en un matériau électriquement conducteur et avec au moins un composant électronique (20) agencé dans un évidement (18) de la première couche (16), dans lequel la première couche (16) est recouverte au-dessus du composant électronique (20) avec une couche (36) électriquement isolante et thermiquement conductive, et sur la couche thermiquement conductrice (36) il est prévu une autre couche (22) en matériau électriquement conducteur, laquelle est à son tour revêtue d'une couche de couverture (38) en matériau électriquement conducteur, et comportant en outre des traversées de contact (24) du matériau de la couche de couverture (38), qui s'étendent à travers la couche (36) électriquement isolante et thermiquement conductrice qui recouvre le composant électronique (20) et à travers l'autre couche (22) en matériau électriquement conducteur et thermiquement conducteur pour la mise en contact du composant électronique (20).

2. Composant électronique (50) selon la revendication 1, dans lequel la première couche (16) est respectivement recouverte d'une couche (34, 36) électriquement isolante et thermiquement conductrice et, sur la couche thermiquement conductrice (34, 36) il est prévu respectivement une autre couche (22, 26) en matériau électriquement conducteur, qui sont respectivement revêtues d'une couche de couverture (38) en matériau électriquement conducteur.

3. Composant électronique (50 ; 50') selon la revendication 1 ou 2, dans lequel, lorsqu'il est prévu plus d'un composant électronique (20), une surface d'étalement de chaleur est associée à chaque composant (20) de telle façon que la surface d'étalement de chaleur est sensiblement égale pour chaque composant monté (20).

4. Procédé pour fabriquer un composant électronique (50 ; 50') comprenant les étapes suivantes :
- on produit un premier produit semi-fini (HZ1) par
- préparation d'un substrat (10) en matériau électriquement conducteur avec une face supérieure (12) et avec une face inférieure (14),
- application/déposition d'une première couche (16) en matériau conducteur sur la face supérieure (12) et/ou sur la face inférieure (14) du substrat (10), et on prévoit dans la première couche (16) au moins un premier évidement (18) pour recevoir un composant électronique,
- on met en place un composant (20) dans ledit au moins un évidement (18),
- on produit un second produit semi-fini (HZ2) par
- préparation d'un premier élément en plaques (22) en matériau électriquement conducteur,
- production de trous traversants (24) pour constituer plus tard des traversées de contact dans le premier élément en plaque (22),
- on dispose les deux produits semi-finis (HZ1, HZ2) dans une structure en couches en déposant le second produit semi-fini (HZ2) sur le premier produit semi-fini (HZ1) avec une couche préimprégnée (36) prévue entre ceux-ci,
- on lamine la structure,
- on dégage les trous (24) remplis de résine après le laminage dans le premier élément en plaque (22),
- on remplit au moins partiellement les trous (24) avec un matériau conducteur (38) pour réaliser les traversées de contact.

5. Procédé pour fabriquer un composant électronique (50) selon la revendication 4, dans lequel on procède, avant l'étape de déposition, à l'étape suivante :
- production d'un troisième produit semi-fini (HZ3) par
- préparation d'un second élément en plaque (26) en matériau électriquement conducteur,
et l'étape de déposition comprend ce qui suit :
- déposition des trois produit semi-finis (HZ1, HZ2, HZ3) dans une structure en couches par pose du premier produit semi-fini (HZ1) sur le troisième produit semi-fini (HZ3) et pose du second produit semi-fini (HZ2) sur le premier produit semi-fini (HZ1) en prévoyant respectivement une couche préimprégnée (34, 36) entre ceux-ci.

6. Procédé selon la revendication 4 ou 5, dans lequel, après l'agencement avec ledit au moins un composant électronique (20) on remplit des dégagements dans l'évidement (18) autour du composant (20) avant le pressage.

7. Procédé selon l'une des revendications 4 à 6, dans lequel on ménage des canaux (K1, K2, K3) dans la première couche (16) et le substrat (10), les canaux comportant des barrettes de maintien (S) que l'on enlève après l'étape de laminage.

8. Procédé selon l'une des revendications 4 à 7, dans lequel on introduit deux couches préimprégnées (36, 37) dans l'étape de pose entre le premier produit semi-fini (HZ1) et le second produit semi-fini (HZ2), et on agence entre les deux couches préimprégnées (36, 37) un autre composant (60) et/ou un organe interposé (IP) que l'on met en contact après l'étape de pressage au moyen de trous (62, 72) plaqués en périphérie.

9. Procédé selon la revendication 8, dans lequel lors de l'étape de production du second produit semi-fini (HZ2) on ménage des trous traversants pour mettre en contact l'autre composant (60) et/ou l'organe interposé (IP).

10. Carte à circuits (LP ; LP') avec un composant électronique (50 ; 50') selon l'une des revendications 1 à 3.

11. Carte à circuits (LP ; LP') selon la revendication 10, dans laquelle une surface de la carte à circuits (LP ; LP') se raccorde en affleurement avec le composant électronique (50 ; 50'), et un corps de refroidissement (120) se raccorde au raccordement en affleurement de la carte à circuits (LP ; LP') et du composant électronique (50 ; 50').

12. Carte à circuits (LP ; LP') selon la revendication 10 ou 11, dans laquelle il est prévu une couche (114) à faible conductivité thermique entre le composant électronique (50 ; 50') et les pistes conductrices (113) de la carte à circuits (LP ; LP') situées au-dessus.

13. Procédé pour intégrer un composant électronique (50, 50') dans une carte à circuits, comprenant les étapes consistant à
- préparer un composant électronique (50, 50') selon l'une des revendications 1 à 3,
- préparer une carte à circuits avec un évidement prévu pour recevoir le composant électronique (50 ; 50'),
- introduire une couche (114) de faible conductivité thermique dans l'évidement,
- metre en place du composant électronique (50 ; 50') dans l'évidement de la carte à circuits sur la couche (114) à faible conductivité thermique,
- presser la structure en couches ainsi formée,
- appliquer une couche électriquement conductrice (118) formant une couche extérieure commune, qui sert également à la mise en contact entre le composant électronique (50, 50') et la carte à circuits (LP ; LP').

14. Procédé selon la revendication 13, dans lequel on applique un corps de refroidissement (120) sur la couche (118) qui forme la couche extérieure commune dans la région du composant électronique (50 ; 50').

15. Procédé selon la revendication 14, dans lequel on introduit une couche TIM (119) pour former une fente thermiquement sans lacune entre la couche électriquement conductrice (118) et le corps de refroidissement (120).

16. Procédé selon l'une des revendications 13 à 15, dans lequel un diélectrique thermiquement conducteur (116) est introduit entre la carte à circuits avec composant électronique mis en place d'une part et la couche extérieure commune (118) d'autre part.
